# EUROPEAN PATENT APPLICATION

(11) **EP 4 734 702 A1**
(43) Date of publication of application: **29.04.2026**
(21) Application number: 24906540.0
(22) Date of filing: 20.12.2024
(51) Int. Cl.: H10F 10/00

(54) **ULTRA-THIN TUNNEL OXIDE PASSIVATED CONTACT SOLAR CELL AND MANUFACTURING METHOD THEREFOR**

(30) Priority: 22.12.2023 CN 202311783183; 22.04.2024 CN 202410488553
(71) Applicant: CHINT New Energy Technology Co., Ltd., Jiaxing, Zhejiang 314400 (CN)
(72) Inventor: HUANG, Haiyan, Jiaxing, Zhejiang 314400 (CN); YU, Hao, Jiaxing, Zhejiang 314400 (CN); CAI, Yongmei, Jiaxing, Zhejiang 314400 (CN); HE, Sheng, Jiaxing, Zhejiang 314400 (CN); HSU, Wei-Chih, Jiaxing, Zhejiang 314400 (CN)
(74) Representative: PGA S.p.A., Milano, Succursale di Lugano
(86) International application number: PCT/CN2024/141000
(87) International publication number: WO 2025/131067

(57) **Abstract**

An ultra-thin tunnel oxide passivated contact solar cell and a manufacturing method therefor. An ultrathin tunnel oxide layer and a doped polycrystalline silicon layer are arranged on the back face of a semiconductor substrate, so as to achieve ultra-thin tunnel oxide passivated contact on the back face. A bottom electrode contact layer is arranged between a bottom electrode and the doped polycrystalline silicon layer. The bottom electrode contact layer comprises: an ultra-thin oxide layer and a doped polycrystalline silicon carbide layer. The doped polycrystalline silicon carbide layer can control the metallization depth of the bottom electrode in the bottom electrode sintering process, so that the bottom electrode and the doped polycrystalline silicon layer form an ohmic contact, and the metallization range does not exceed the doped polycrystalline silicon layer, so as to prevent the metal material of the sintered bottom electrode from burning the ultra-thin tunnel oxide layer, prevent causing a problem of poor ultra-thin tunnel oxide passivated contact effect, improve the ultra-thin tunnel oxide passivated contact effect, prevent the metal material of the bottom electrode from being in direct contact with the semiconductor substrate, reduce metal contact compounding, reduce parasitic absorption, and improve the photoelectric conversion efficiency.

## Description

This application claims priority to Chinese Patent Application No. 202311783183.4, titled "ULTRA-THIN TUNNEL OXIDE PASSIVATED CONTACT SOLAR CELL AND MANUFACTURING METHOD THEREFOR", filed on December 22, 2023 with the China National Intellectual Property Administration, and Chinese Patent Application No. 202410488553.X, titled "TOPCON SOLAR CELL AND MANUFACTURING METHOD THEREFOR", filed on April 22, 2024 with the China National Intellectual Property Administration, which are incorporated herein by reference in its entirety.

### FIELD

The present application relates to the field of solar cell technology, and in particular to an ultra-thin tunnel oxide passivated contact solar cell and a manufacturing method therefor.

### BACKGROUND

The increasing shortage of fossil energy has a serious impact on the sustainable development of economy and the health and environment of human. In addition, the degradation of the ecological environment and the depletion of traditional energy sources have created an urgent need for clean, pollution-free, and sustainably developable green energy. Among these, solar energy stands out as particularly crucial due to its high potential as a sustainably exploitable clean energy source.

Solar cells currently represent a primary method for people to harnessing solar energy. An ultra-thin oxide layer and a polycrystalline silicon layer are arranged on the rear surface of the TOPCon solar cell, to achieve the ultra-thin tunnel oxide passivated contact. This design not only ensures a good rear-side passivation effect, but also use the quantum tunneling effect to allow majority carriers to tunnel through and block minority carriers, thereby achieving selective carriers collection, and improving photoelectric conversion efficiency. Furthermore, the manufacturing process of the TOPCon solar cell has good compatibility with the manufacturing process of the conventional passivated emitter and rear cell (PERC).

However, existing TOPCon solar cells face issues such as poor passivation contact performance of the ultra-thin tunnel oxide layer and affect the photoelectric conversion efficiency.

In addition, in the conventional TopCon (Tunnel Oxide Passivated Contact) solar cell, a tunnel layer and a doped polycrystalline silicon layer are sequentially arranged as passivation layers on an entire surface of the substrate. However, the material structure and doping concentration of the doped polycrystalline silicon layer result in a relatively high light absorption coefficient for the doped polycrystalline silicon layer in the conventional TopCon solar cell, which results in the serious parasitic absorption problem. This problem will affect the short-circuit current and bifaciality ratio of the cell. Therefore, it is necessary to provide a TopCon solar cell and a manufacturing method thereof to solve the parasitic absorption problem in the related art.

### SUMMARY

In view of the above, the present application provides an ultra-thin tunnel oxide passivated contact solar cell and a manufacturing method thereof. The solutions are as follows:

A TOPCon solar cell, comprising:
a semiconductor substrate, where the semiconductor substrate has a front surface and a rear surface opposite to each other, and the rear surface has a metallic grid line region and a non-metallic grid line region located on both sides of the metallic grid line region;
an ultra-thin tunnel oxide layer covering the rear surface;
a doped polycrystalline silicon layer covering the ultra-thin tunnel oxide layer;
a patterned bottom electrode contact layer, located on a surface of the doped polycrystalline silicon layer away from the ultra-thin tunnel oxide layer and located in the metallic grid line region; and
a bottom electrode, located on a surface of the bottom electrode contact layer away from the doped polycrystalline silicon layer;
where the bottom electrode contact layer comprises: an ultra-thin oxide layer located on the surface of the doped polycrystalline silicon layer and a doped polycrystalline silicon carbide layer located on a surface of the ultra-thin oxide layer, and the doped polycrystalline silicon carbide layer is configured to control a metallization depth of the bottom electrode during a sintering process of the bottom electrode, such that the bottom electrode is in an ohmic contact with the doped polycrystalline silicon layer and a metallization range does not exceed the doped polycrystalline silicon layer.

Preferably, in the above-mentioned TOPCon solar cell, a thickness of the doped polycrystalline silicon layer ranges from 10 nm to 40 nm.

Preferably, in the above-mentioned TOPCon solar cell, a thickness of the doped polycrystalline silicon carbide layer ranges from 40 nm to 140 nm.

Preferably, in the above-mentioned TOPCon solar cell, a spacing between two adjacent bottom electrodes ranges from 0.85 mm to 0.95 mm.

Preferably, the above-mentioned TOPCon solar cell further comprises:
a silicon nitride passivation layer, where the silicon nitride passivation layer is located on the surface of the doped polycrystalline silicon layer away from the ultra-thin tunnel oxide layer and located in the non-metallic grid line region while exposing the bottom electrode contact layer.

Preferably, in the above-mentioned TOPCon solar cell, a thickness of the silicon nitride passivation layer is 70 nm to 150 nm, inclusive of both endpoints.

Preferably, in the above-mentioned TOPCon solar cell, a light absorption coefficient of the doped polycrystalline silicon carbide layer is less than a light absorption coefficient of the doped polycrystalline silicon layer.

Preferably, in the above-mentioned TOPCon solar cell, an activated impurity concentration of the doped polycrystalline silicon layer is 1×10 ²⁰ cm⁻³ to 1×10²¹ cm⁻³, inclusive of both endpoints.

Preferably, in the above-mentioned TOPCon solar cell, an activated impurity concentration of the doped polycrystalline silicon carbide layer is 1×10 ²⁰ cm⁻³ to 1×10 ²¹ cm⁻³, inclusive of both endpoints.

Preferably, in the above-mentioned TOPCon solar cell, a width of the metallic grid line region is 80 µm to 200 µm, inclusive of both endpoints, and a width of the non-metallic grid line region is 1000 µm to 2000 µm, inclusive of both endpoints.

The present application further provides a method for manufacturing any one of the above-mentioned TOPCon solar cells, comprising:
providing the semiconductor substrate, where the semiconductor substrate has a front surface and a rear surface opposite to each other, and the rear surface has a metallic grid line region and a non-metallic grid line region located on both sides of the metallic grid line region;
forming the ultra-thin tunnel oxide layer covering the rear surface;
forming the doped polycrystalline silicon layer and the bottom electrode contact layer, where the doped polycrystalline silicon layer covers the ultra-thin tunnel oxide layer, the patterned bottom electrode contact layer is formed on the surface of the doped polycrystalline silicon layer away from the ultra-thin tunnel oxide layer and located in the metallic grid line region; and
forming the bottom electrode on the surface of the bottom electrode contact layer away from the doped polycrystalline silicon layer;
where the bottom electrode contact layer comprises: the ultra-thin oxide layer located on the surface of the doped polycrystalline silicon layer and the doped polycrystalline silicon carbide layer located on the surface of the ultra-thin oxide layer, and the doped polycrystalline silicon carbide layer is configured to control the metallization depth of the bottom electrode during the sintering process of the bottom electrode, such that the bottom electrode is in an ohmic contact with the doped polycrystalline silicon layer and the metallization range does not exceed the doped polycrystalline silicon layer.

Preferably, in the above-mentioned method, the ultra-thin tunnel oxide layer, a doped amorphous silicon layer, a non-patterned bottom electrode contact layer and a non-patterned mask layer are sequentially formed on the rear surface by using a same PECVD equipment;
where the doped amorphous silicon layer is for forming the doped polycrystalline silicon layer based on an annealing process; the bottom electrode contact layer is patterned based on the mask layer, and then the mask layer is removed.

Preferably, in the above-mentioned method, a thickness of the doped polycrystalline silicon layer ranges from 10 nm to 40 nm.

Preferably, in the above-mentioned method, a thickness of the doped polycrystalline silicon carbide layer ranges from 40 nm to 140 nm;
and/or, a spacing between two adjacent bottom electrodes ranges from 0.85 mm to 0.95 mm.

Preferably, in the above-mentioned method, a method for forming the doped polycrystalline silicon layer and the bottom electrode contact layer comprises:
forming the doped amorphous silicon layer on a surface of the ultra-thin tunnel oxide layer;
forming a non-patterned ultra-thin oxide layer and a non-patterned doped amorphous silicon carbide layer in sequence on a surface of the doped polycrystalline silicon layer;
forming a mask layer on a surface of the doped amorphous silicon carbide layer away from the ultra-thin oxide layer, and then annealing to convert the doped amorphous silicon layer into the doped polycrystalline silicon layer and convert the doped amorphous silicon carbide layer into the doped polycrystalline silicon carbide layer;
patterning the mask layer, where the patterned mask layer covers the doped polycrystalline silicon carbide layer located in the metallic grid line region and exposes the doped polycrystalline silicon carbide layer located in the non-metallic grid line region;
etching and removing the doped polycrystalline silicon carbide layer located in the non-metallic grid line region based on the patterned mask layer; and
simultaneously removing the ultra-thin oxide layer and the mask layer located in the non-metallic grid line region; where the ultra-thin oxide layer and the mask layer are made of the same material.

It can be seen from the above description that in the ultra-thin tunnel oxide passivated contact solar cell and the manufacturing method provided by the technical solution of the present application, the ultra-thin tunnel oxide layer and the doped polycrystalline silicon layer are arranged on the rear surface of the semiconductor substrate, which can realize the ultra-thin tunnel oxide passivation contact on the rear surface. In addition, the bottom electrode contact layer is arranged between the bottom electrode and the doped polycrystalline silicon layer. The bottom electrode contact layer comprises: the ultra-thin oxide layer and the doped polycrystalline silicon carbide layer, and the doped polycrystalline silicon carbide layer can control the metallization depth of the bottom electrode during the sintering process of the bottom electrode, so that the bottom electrode is in an ohmic contact with the doped polycrystalline silicon layer, and the metallization range does not exceed the doped polycrystalline silicon layer. This can prevent the metal material of the bottom electrode from burning through the ultra-thin tunnel oxide layer after sintering, thereby avoiding the problem of poor effect of the ultra-thin tunnel oxide passivation contact caused thereby, and improving the ultra-thin tunnel oxide passivated contact effect. It prevents the metal material of the bottom electrode from directly contacting the semiconductor substrate, reduces the metal contact recombination, thereby reducing parasitic absorption and improving photoelectric conversion efficiency.

The present application further provides a TopCon cell and a method for manufacturing the TopCon cell. The solutions are as follows:

A TopCon cell comprises: a substrate, wherein a surface of the substrate has a metallic contact region and a non-metallic contact region;
a first tunnel layer, a doped polycrystalline silicon layer and an electrode, wherein the first tunnel layer, the doped polycrystalline silicon layer and the electrode are located in sequence in the metallic contact region along a direction away from the substrate, and the electrode is in ohmic contact with the doped polycrystalline silicon layer; and
a second tunnel layer and a doped polycrystalline silicon carbide layer, wherein the second tunnel layer and the doped polycrystalline silicon carbide layer are located in sequence in the non-metallic contact region along a direction away from the substrate, and a light absorption coefficient of the doped polycrystalline silicon carbide layer is less than a light absorption coefficient of the doped polycrystalline silicon layer.

Optionally, the second tunnel layer covers the doped polycrystalline silicon layer and the non-metallic contact region; the doped polycrystalline silicon carbide layer covers the second tunnel layer;
the electrode penetrates the doped polycrystalline silicon carbide layer and the second tunnel layer, and is in ohmic contact with the doped polycrystalline silicon layer.

In one embodiment, the TopCon cell further comprises: a passivating antireflection layer; where the passivating antireflection layer covers a surface of the doped polycrystalline silicon carbide layer away from the substrate;
the electrode penetrates the passivating antireflection layer, the doped polycrystalline silicon carbide layer and the second tunnel layer, and is in ohmic contact with the doped polycrystalline silicon layer.

Optionally, the passivating antireflection layer comprises any one or more selected from the group consisting of a silicon nitride layer, a silicon oxynitride layer, a silicon oxide layer, an aluminum oxide layer, an aluminum nitride layer, an aluminum oxynitride layer and a magnesium fluoride layer.

Optionally, a thickness of the passivating antireflection layer is 70 nm to 150 nm, inclusive of both endpoints.

Optionally, an activated impurity concentration of the doped polycrystalline silicon layer is 1×10 ²⁰ cm⁻³ to 1×10 ²¹ cm⁻³, inclusive of both endpoints;
a thickness of the doped polycrystalline silicon layer is 20 nm to 100 nm, inclusive of both endpoints.

Optionally, an activated impurity concentration of the doped polycrystalline silicon carbide layer is 1×10 ²⁰ cm⁻³ to 1×10 ²¹ cm⁻³, inclusive of both endpoints;
a thickness of the doped polycrystalline silicon carbide layer is 20 nm to 50 nm, inclusive of both endpoints.

Optionally, a width of the metallic contact region is 80 µm to 200 µm, inclusive of both endpoints; a width of the non-metallic contact region is 1000 µm to 2000 µm, inclusive of both endpoints.

Optionally, the doped polycrystalline silicon carbide layer located in the metallic contact region is configured to control a metallization depth of the electrode during a sintering process of the electrode, such that the electrode is in an ohmic contact with the doped polycrystalline silicon layer located in the metallic contact region, and the metallization range does not exceed the metallic contact region.

Optionally, a spacing between two adjacent electrodes ranges from 0.85 mm to 0.95 mm. To achieve the above purpose, the present application further provides a method for manufacturing a TopCon cell, comprising:
preparing a first tunnel layer and a doped polycrystalline silicon layer in sequence in a metallic contact region on a surface of a substrate along a direction away from the substrate;
preparing a second tunnel layer and a doped polycrystalline silicon carbide layer in sequence in a non-metallic contact region on the surface of the substrate along the direction away from the substrate, wherein a light absorption coefficient of the doped polycrystalline silicon carbide layer is less than a light absorption coefficient of the doped polycrystalline silicon layer;
after preparing the doped polycrystalline silicon layer and the doped polycrystalline silicon carbide layer, preparing an electrode in the metallic contact region such that the electrode is in ohmic contact with the doped polycrystalline silicon layer.

Optionally, the preparing the second tunnel layer and the doped polycrystalline silicon carbide layer in sequence in the non-metallic contact region on the surface of the substrate along the direction away from the substrate comprises:
after preparing the doped polycrystalline silicon layer, preparing the second tunnel layer and the doped polycrystalline silicon carbide layer in sequence on the doped polycrystalline silicon layer and in the non-metallic contact region along the direction away from the substrate;
correspondingly, preparing the electrode in the metallic contact region such that the electrode is in ohmic contact with the doped polycrystalline silicon layer comprises:
   preparing the electrode, such that the electrode penetrates the doped polycrystalline silicon carbide layer and the second tunnel layer, and is in ohmic contact with the doped polycrystalline silicon layer.

Apparently, the TopCon cell provided in the present application has an optimized passivation layer structure. The doped polycrystalline silicon layer is retained in the metallic contact region, and it forms a high-low junction with the substrate to provide field passivation and forms the ohmic contact with the electrode. The doped polycrystalline silicon carbide layer is provided in the non-metallic contact region, and it forms a heterojunction with the substrate to provide field passivation and serve as a lateral carrier transport layer. On the one hand, the parasitic absorption of the passivation layer is reduced by removing the doped polycrystalline silicon layer in the non-metallic contact region. Moreover, due to the low light absorption coefficient and small thickness of the doped polycrystalline silicon carbide layer, the parasitic absorption can also be reduced. On the other hand, by retaining the doped polycrystalline silicon layer in the metallic contact region to form the ohmic contact with the electrode, lower recombination loss can be ensured when the doped polycrystalline silicon layer contacts the metal grid line. In addition, the field passivation is formed in both the metallic contact region and the non-metallic region, which ensures the passivation effect of the entire surface of the substrate. The present application further provides a method for manufacturing the TopCon cell, and the TopCon cell prepared by the method also has the above-mentioned beneficial effects.

### BRIEF DESCRIPTION OF THE DRAWINGS

In order to illustrate technical solutions in embodiments of the present application or related technologies more clearly, drawings required for use in the embodiments or descriptions of conventional technology will be briefly introduced as follows. Apparently, the drawings described below are only embodiments of the present application. For those skilled in the art, other drawings can be obtained based on the provided drawings without creative work.

The structures, proportions, sizes, or the like shown in the drawings of the description are only used to match contents disclosed in the description for those skilled in the art to understand and read, and are not used to limit the restrictive conditions that can be implemented in the present application. Therefore, the structures, proportions, sizes, or the like have no technical substantive significance. Any structural modification, change in proportional relationship or adjustment of size, without affecting the efficacy and purpose that can be achieved by the present application, should fall within the scope of the technical content disclosed in the present application.
FIG. 1 is a cross-sectional view of a TOPCon solar cell provided in an embodiment of the present application.
FIG. 2 is a cross-sectional view of a TOPCon solar cell provided in another embodiment of the present application.
FIG. 3 is a cross-sectional view of a TOPCon solar cell provided in another embodiment of the present application;
FIGs. 4-13 are structural schematic diagrams of a method for manufacturing a TOPCon solar cell provided in an embodiment of the present application at different process steps.
Description of reference numerals:

| | | | |
|---|---|---|---|
| 10: | semiconductor substrate; | 11: | ultra-thin tunnel oxide layer; |
| 12: | doped polycrystalline silicon layer; | 13: | bottom electrode contact layer; |
| 14: | bottom electrode; | 131: | ultra-thin oxide layer; |
| 132: | doped polycrystalline silicon carbide layer; | 15: | silicon nitride passivation layer; |
| 21: | diffusion layer; | 22: | front-side passivation structure; |
| 23: | top electrode; | 12': | doped amorphous silicon layer; |
| 132': | doped amorphous silicon carbide layer; | 16: | mask layer. |

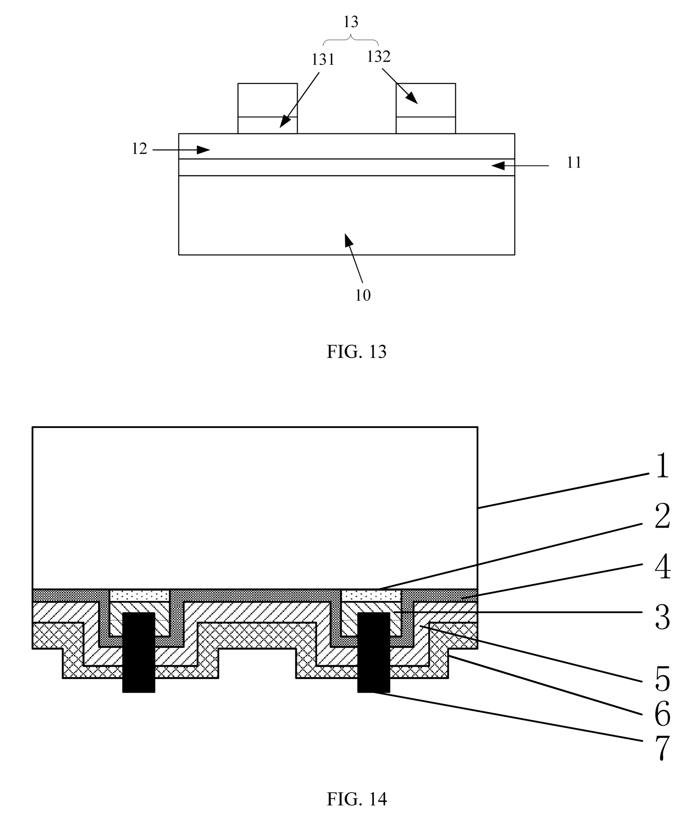

FIG. 14 is a schematic structural diagram of a TopCon solar cell provided in an embodiment of the present application.

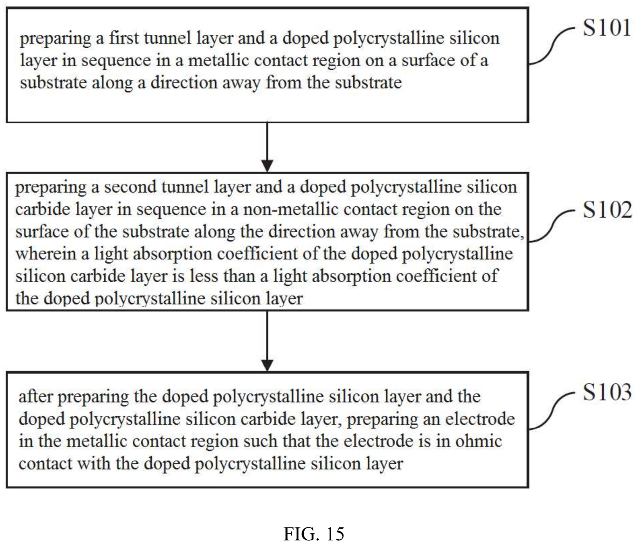

FIG. 15 is a flow chart of a method for manufacturing a TopCon solar cell provided in an embodiment of the present application.
Description of reference numerals is as follows:

| | | | |
|---|---|---|---|
| 1: | substrate; | 2: | first tunnel layer; |
| 3: | doped polycrystalline silicon layer; | 4: | second tunnel layer; |
| 5: | doped polycrystalline silicon carbide layer; | 6: | passivating antireflection layer; |
| 7: | electrode. | | |

### DETAILED DESCRIPTION OF EMBODIMENTS

The embodiments of the present application will be clearly and completely described below with reference to the accompanying drawings in the embodiments of the present application. Apparently, the described embodiments are only part of, not all of the embodiments of the present application. Based on the embodiments in the present application, all other embodiments obtained by those skilled in the art without making creative work are within the scope of protection of the present application.

It is obvious to those skilled in the art that various modifications and changes can be made in the present application without departing from the spirit or scope of the present application. Therefore, the present application is intended to cover modifications and changes of the present application that fall within the scope of the corresponding claims (technical solutions claimed for protection) and their equivalents. It should be noted that the implementation methods provided in the embodiments of the present application can be combined with each other without contradiction.

In order to make the above-mentioned purposes, features and advantages of the present application more clearly understandable, the present application is further described in detail below in conjunction with the drawings and specific implementation methods.

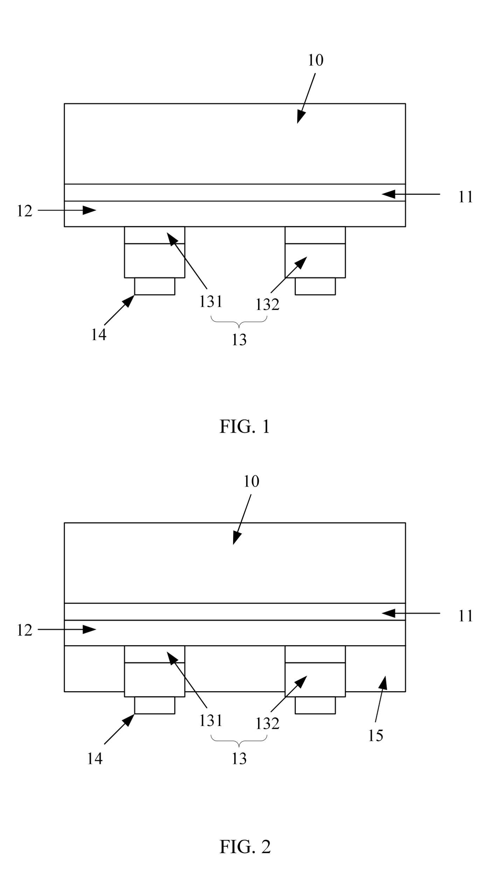

Reference is made to FIG. 1, which is a cross-sectional view of a TOPCon solar cell provided in an embodiment of the present application. The TOPCon solar cell comprises:
a semiconductor substrate 10, where the semiconductor substrate 10 has a front surface and a rear surface opposite to each other, and the rear surface has a metallic grid line region and a non-metallic grid line region located on both sides of the metallic grid line region;
an ultra-thin tunnel oxide layer 11 covering the rear surface;
a doped polycrystalline silicon layer 12 covering the ultra-thin tunnel oxide layer 11;
a patterned bottom electrode contact layer 13, where the bottom electrode contact layer 13 is located on a surface of the doped polycrystalline silicon layer 12 away from the ultra-thin tunnel oxide layer 11 and located in the metallic grid line region; and
a bottom electrode 14, located on a surface of the bottom electrode contact layer 13 away from the doped polycrystalline silicon layer 12;
where the bottom electrode contact layer 13 comprises: an ultra-thin oxide layer 131 located on the surface of the doped polycrystalline silicon layer 12 and a doped polycrystalline silicon carbide layer 132 located on a surface of the ultra-thin oxide layer 131, and the doped polycrystalline silicon carbide layer 132 is configured to control a metallization depth of the bottom electrode 14 during a sintering process of the bottom electrode 14, such that the bottom electrode 14 is in an ohmic contact with the doped polycrystalline silicon layer 12, and a metallization range does not exceed the doped polycrystalline silicon layer 12, avoiding damage to the ultra-thin tunnel oxide layer 11 between the doped polycrystalline silicon layer 12 and the semiconductor substrate 10, so as to ensure good ultra-thin tunnel oxide passivated contact.

The TOPCon passivation structure can be realized on the rear surface of the semiconductor substrate 10 through the ultra-thin tunnel oxide layer 11 and the doped polycrystalline silicon layer 12, thereby improving the passivation effect of the cell.

In the TOPCon solar cell provided in the embodiment of the present application, the bottom electrode contact layer 13 is provided with a doped polycrystalline silicon carbide layer 132, and the doped polycrystalline silicon carbide layer 132 can control the metallization depth of the bottom electrode 14 during the sintering process of the bottom electrode 14, so that the bottom electrode 14 forms an ohmic contact with the doped polycrystalline silicon layer 12, and the metallization range does not exceed the doped polycrystalline silicon layer 12. This can prevent the metal material of the bottom electrode 14 from burning through the ultra-thin tunnel oxide layer 11 after sintering, thereby avoiding the problem of poor effect of the ultra-thin tunnel oxide passivation contact caused thereby, and improving the ultra-thin tunnel oxide passivated contact effect. It prevents the metal material of the bottom electrode 14 from directly contacting the semiconductor substrate 10, reduces the metal contact recombination, thereby reducing parasitic absorption and improving photoelectric conversion efficiency.

Optionally, the semiconductor substrate 10 is an N-type doped silicon substrate. The ultra-thin tunnel oxide layer 11 is a silicon oxide layer. The doped polycrystalline silicon layer 12 can be phosphorus-doped polycrystalline silicon. The ultra-thin oxide layer 131 is a silicon oxide layer. The doped polycrystalline silicon carbide layer 132 is a phosphorus-doped polycrystalline silicon carbide layer.

In the conventional TOPCon solar cell, a thickness of the doped polycrystalline silicon layer 12 is generally about 120 nm, which is relatively large. The gain in short-circuit current density of the solar cell is approximately 0.2 mA/cm² to 0.4 mA/cm², which is relatively small. Although reducing the thickness of the doped polycrystalline silicon layer 12 can enhance the gain in short-circuit current density of the solar cell, it will weaken the lateral carrier transport performance within the doped polycrystalline silicon layer 12. Moreover, after the electrode is sintered, the reduction in the thickness of the doped polycrystalline silicon layer 12 is more likely to cause the metal material in the bottom electrode 14 to burn through the ultra-thin tunnel oxide layer11, affecting the photoelectric conversion efficiency.

In the TOPCon solar cell provided in the embodiment of the present application, a thinner doped polycrystalline silicon layer 12 can be used. Despite the reduced thickness of the doped polycrystalline silicon layer 12, the doped polycrystalline silicon carbide layer 132 can solve the problem of metal material burning through the ultra-thin tunnel oxide layer 11 caused by the reduced thickness of the doped polycrystalline silicon layer 12. Reducing a distance between the bottom electrodes 14 can overcome the problem of weakened lateral carrier transport performance within the doped polycrystalline silicon layer 12 due to its reduced thickness. In this way, while improving the gain in short-circuit current density of the solar cell, a loss of fill factor can be reduced to within the absolute value of 0.3%, thereby enabling the final photoelectric conversion efficiency of the solar cell to achieve an absolute gain of exceeding 0.1%.

Based on the above description, it can be seen that compared to conventional TOPCon solar cells, in one embodiment of the present application, the thickness of the doped polycrystalline silicon layer 12 can be reduced from 120 nm to no more than 40 nm, for example, the thickness of the doped polycrystalline silicon layer 12 can be set in the range from 10 nm to 40 nm. The significant reduction in the thickness of the doped polycrystalline silicon layer 12 can effectively improve the gain in short-circuit current density of the solar cell.

Optionally, the thickness of the doped polycrystalline silicon carbide layer 132 is set to range from 40 nm to 140 nm. When the thickness of the doped polycrystalline silicon carbide layer 132 ranges from 40 nm to 140 nm, the thickness of the doped polycrystalline silicon layer 12 can be reduced to no more than 40nm, and the problem of the metal material burning through the ultra-thin tunnel oxide layer 11 caused by the reduced thickness of the doped polycrystalline silicon layer 12 can be effectively solved.

Optionally, based on the doped polycrystalline silicon carbide layer 132 of a certain thickness, the electrode contact portion formed by the bottom electrode 14 after sintering may be located on a side of the ultra-thin oxide layer 131 away from the rear surface of the semiconductor substrate 10, that is, the bottom electrode 14 does not run through the ultra-thin oxide layer 131. This is because a heterojunction structure is formed between the doped polycrystalline silicon layer 12 and the doped polycrystalline silicon carbide layer 132, which facilitates the separation and transport of photogenerated carriers. However, effective surface passivation between different semiconductors is required to reduce interface defects. The ultra-thin oxide layer 131 can effectively passivate the surfaces of both the doped polycrystalline silicon layer 12 and the doped polycrystalline silicon carbide layer 132. Moreover, due to its extremely low thickness, the ultra-thin oxide layer 131 can cause electron tunnel, further enhancing carrier separation and reducing recombination.

In some embodiments of the present application, the spacing between two adjacent bottom electrodes 14 is set to range from 0.85 mm to 0.95 mm. When the spacing between the two adjacent bottom electrodes 14 is in the range of 0.85 mm to 0.95 mm, the thickness of the doped polycrystalline silicon layer 12 can be controlled to no more than 40 nm, and the weakened lateral carrier transport performance in the doped polycrystalline silicon layer 12 due to its reduced thickness can be effectively overcome. In one embodiment of the present application, the thickness of the doped polycrystalline silicon carbide layer 132 is set in the range of 40 nm to 140 nm, and the spacing between two adjacent bottom electrodes 14 is set in the range of 0.85 mm to 0.95 mm, the thickness of the doped polycrystalline silicon layer 12 can be greatly reduced to no more than 30 nm. The doped polycrystalline silicon layer 12 with a thickness of 20 nm to 30 nm can be used, which not only effectively solves the problem of the metal material burning through the ultra-thin tunnel oxide layer 11 caused by the reduced thickness of the doped polycrystalline silicon layer 12, but also overcomes the weakened lateral carrier transport performance in the doped polycrystalline silicon layer 12 due to its reduced thickness.

Reference is made to FIG. 2, which is a cross-sectional view of a TOPCon solar cell provided in another embodiment of the present application. Based on the above implementation, the TOPCon solar cell shown in FIG. 2 further comprises: a silicon nitride passivation layer 15 located on the surface of the doped polycrystalline silicon layer 12 away from the ultra-thin tunnel oxide layer 11. The silicon nitride passivation layer 15 is located in the non-metallic grid line region, and the bottom electrode contact layer 13 is exposed.

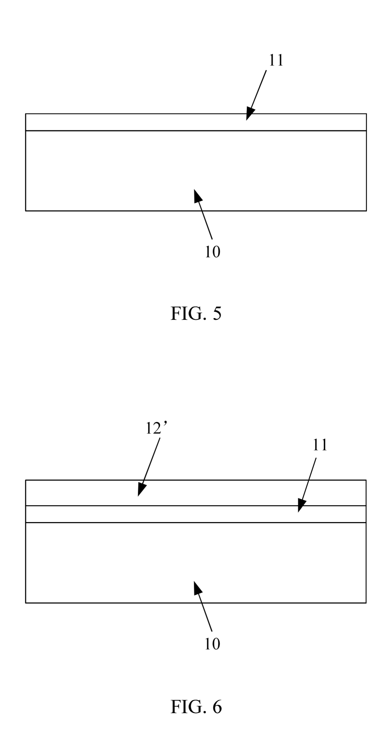

In the embodiment shown in FIG. 5, the rear surface of the battery not only has a TOPCon passivation structure formed by the ultra-thin tunnel oxide layer 11 and the doped polycrystalline silicon layer 12, but also has a silicon nitride passivation layer 15, which improves the passivation effect on the rear surface of the solar cell. The silicon nitride passivation layer 15 has good chemical stability, and may also prevent the metal material of the bottom electrode 14 from damaging other layers in the non-metallic grid line region during the subsequent sintering process of the bottom electrode. Moreover, the silicon nitride passivation layer 15 may further improve the anti-reflection effect.

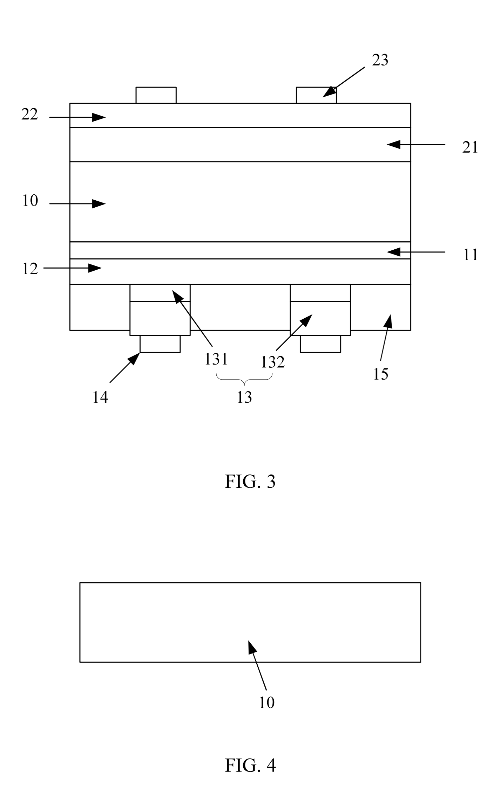

Reference is made to FIG. 3, which is a cross-sectional view of a TOPCon solar cell provided in another embodiment of the present application. Based on the above-mentioned embodiment, in the TOPCon solar cell shown in FIG. 3, a diffusion layer 21 is provided on the front surface of the semiconductor substrate 10, a front passivation structure 22 is covered on a surface of the diffusion layer 21, and a top electrode 23 is provided on a surface of the front passivation structure 22.

Herein, when the semiconductor substrate 10 is an N-type doped silicon substrate, the diffusion layer 21 may be a P-type doped diffusion layer.

Conductive slurry is used to form the top electrode 23 and the bottom electrode 14 by screen printing process, and then a sintering process is performed to achieve a good ohmic contact between the top electrode 23 and the diffusion layer 21 and between the bottom electrode 14 and the doped polycrystalline silicon layer 12. Through the sintering process, the metal material of the electrode and the silicon material of the lower layer can reach a eutectic temperature under heating to form an alloy system. When the temperature drops to a certain range, the silicon atoms in the alloy system will recrystallize to form the good ohmic contact.

In one embodiment, the light absorption coefficient of the doped polycrystalline silicon carbide layer 132 is less than the light absorption coefficient of the doped polycrystalline silicon layer 12. Although the above-mentioned doped polycrystalline silicon carbide layer 132 is patterned, the width of the doped polycrystalline silicon carbide layer 132 is generally greater than the width of the bottom electrode 14 after sintering. That is, a portion of the doped polycrystalline silicon carbide layer 132 that is not blocked by the bottom electrode 14 is still exposed on the rear surface of the solar cell. Setting the light absorption coefficient of the doped polycrystalline silicon carbide layer 132 to be less than the light absorption coefficient of the doped polycrystalline silicon layer 12 can reduce parasitic absorption.

Specifically, in one embodiment, the thickness of the silicon nitride passivation layer 15 is generally 70 nm to 150 nm, inclusive of both endpoints. The activated impurity concentration of the doped polycrystalline silicon layer 12 is generally 1×10 ²⁰ cm⁻³ to 1×10 ²¹cm⁻³, inclusive of both endpoints. The activated impurity concentration of the doped polycrystalline silicon carbide layer 132 is generally 1×10 ²⁰ cm⁻³ to 1×10 ²¹ cm⁻³, inclusive of both endpoints.

Specifically, in one embodiment, the width of the metallic grid line region is generally 80 µm to 200 µm, inclusive of both endpoints, the width of the non-metallic grid line region is generally 1000 µm to 2000 µm, inclusive of both endpoints.

Based on the TOPCon solar cell provided in the above embodiment, another embodiment of the present application further provides a method for manufacturing the above TOPCon solar cell.

Reference is made to FIGs. 4 to 12, which are schematic structural diagrams of the method for manufacturing the TOPCon solar cell provided in another embodiment of the present application at different process steps. The method comprises as follows.

Step S11: as shown in FIG. 4, a semiconductor substrate 10 is provided.

Herein, the semiconductor substrate 10 has a front surface and a rear surface opposite to each other, and the rear surface has a metallic grid line region and a non-metallic grid line region located on both sides of the metallic grid line region.

Step S12: as shown in FIG. 5, an ultra-thin tunnel oxide layer 11 covering the rear surface is formed.

The ultra-thin tunnel oxide layer 11 may be formed on the rear surface of the semiconductor substrate 10 by using PECVD process with N₂O ionization. Optionally, the thickness of the ultra-thin tunnel oxide layer 11 may range from 0.8 nm to 2 nm.

Step S13: as shown in FIG. 6 to FIG. 13, a doped polycrystalline silicon layer 12 and a bottom electrode contact layer 13 are formed.

Herein, the doped polycrystalline silicon layer 12 covers the ultra-thin tunnel oxide layer 11, a patterned bottom electrode contact layer 13 is formed on the surface of the doped polycrystalline silicon layer 12 away from the ultra-thin tunnel oxide layer 11, and the bottom electrode contact layer 13 is located in the metallic grid line region.

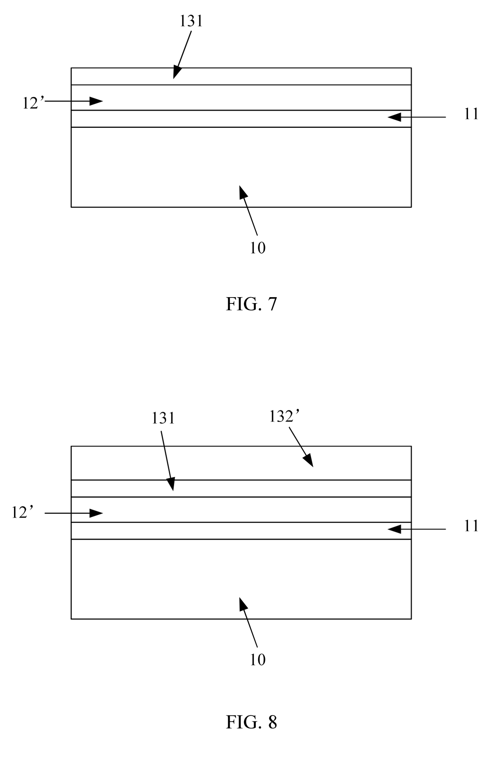

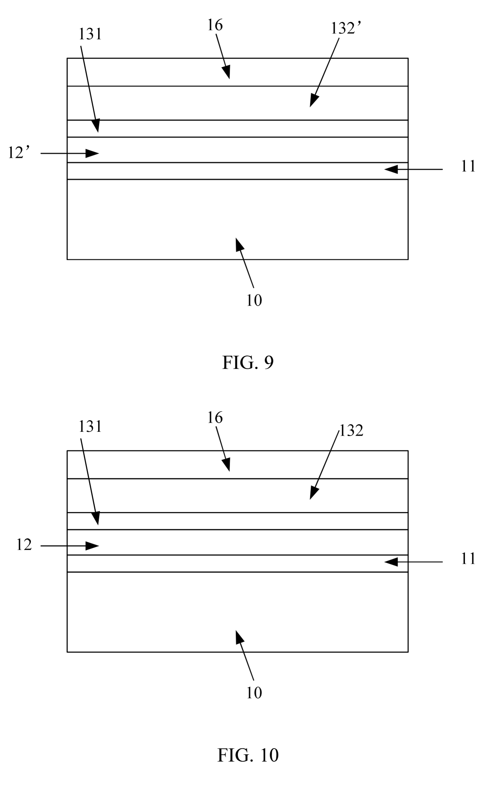

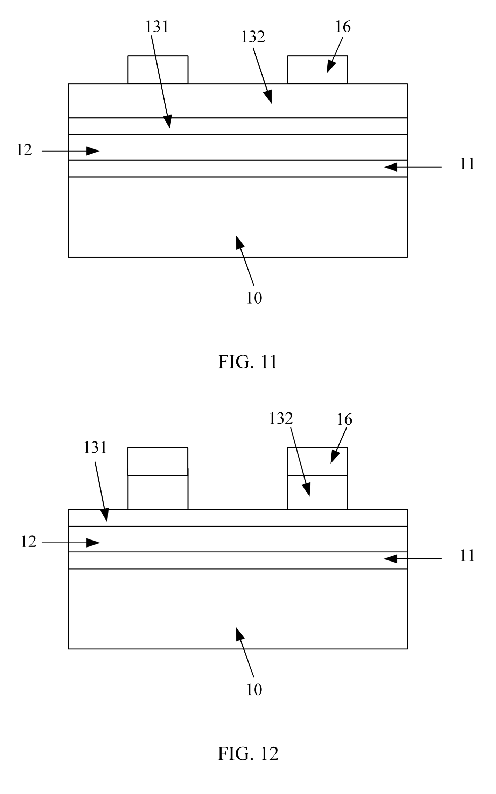

In this step, the method for forming the doped polycrystalline silicon layer 12 and the bottom electrode contact layer 13 comprises: as shown in FIG. 6, forming a doped amorphous silicon layer 12' on the surface of the ultra-thin tunnel oxide layer 11; as shown in FIG. 7 and FIG. 8, sequentially forming a non-patterned ultra-thin oxide layer 131 and a non-patterned doped amorphous silicon carbide layer 132' on the surface of the doped amorphous silicon layer 12'; as shown in FIG. 9, forming a mask layer 16 on the surface of the doped amorphous silicon carbide layer 132' away from the ultra-thin oxide layer 131, and then as shown in FIG. 10, annealing to convert the doped amorphous silicon layer 12' into the doped polycrystalline silicon layer 12, and convert the doped amorphous silicon carbide layer 132' into the doped polycrystalline silicon carbide layer 12; as shown in FIG. 11, patterning the mask layer 16, where the patterned mask layer 16 covers the doped polycrystalline silicon carbide layer 132 located in the metallic grid line region, and exposes the doped polycrystalline silicon carbide layer 132 located in the non-metallic grid line region; as shown in FIG. 12, based on the patterned mask layer 16, etching and removing the doped polycrystalline silicon carbide layer 132 located in the non-metallic grid line region; as shown in FIG. 13, simultaneously removing the ultra-thin oxide layer 131 and the mask layer 16 located in the non-metallic grid line region, where the ultra-thin oxide layer 131 and the mask layer 16 are made of the same material.

A PECVD process can be used to deposit a phosphorus-containing doped amorphous silicon layer 12' by ionizing SiH₄ and PH₃, so as to facilitate subsequent annealing to form the doped polycrystalline silicon layer 12. In one embodiment, the thickness of the doped amorphous silicon layer 12' can range from 10 nm to 40 nm, and the corresponding thickness of the doped polycrystalline silicon layer 12 can range from 10 nm to 40 nm.

Step S14: the bottom electrode 14 is formed on the surface of the bottom electrode contact layer 13 away from the polycrystalline silicon layer 12 to form a solar cell structure as shown in FIG. 1.

The manufacturing method shown in FIGs. 4 to 13 is described by taking the solar cell structure shown in FIG. 1 as an example. For the front surface structure of the battery, reference can be made to the manufacturing method of the front structure of conventional TOPCon solar cells, which will not be repeated in this embodiment of the present application.

Herein, the bottom electrode contact layer 13 comprises: the ultra-thin oxide layer 131 located on the surface of the doped polycrystalline silicon layer 12 and the doped polycrystalline silicon carbide layer 132 located on the surface of the ultra-thin oxide layer 131, and the doped polycrystalline silicon carbide layer 132 is configured to control the metallization depth of the bottom electrode 14 during the sintering process of the bottom electrode 14, so that the bottom electrode 14 is in an ohmic contact with the doped polycrystalline silicon layer 12, and the metallization range does not exceed the doped polycrystalline silicon layer 12.

In step S13, the method for forming the bottom electrode contact layer 13 comprises the steps as follows.

Step S141: as shown in FIG. 7, a non-patterned ultra-thin oxide layer 131 is formed. The ultra-thin oxide layer 131 may be formed on the surface of the doped amorphous silicon layer 12' by using the PECVD process with N₂O ionization. Optionally, the thickness of the ultra-thin oxide layer 131 ranges from 0.8 nm to 2 nm.

Step S142: as shown in FIG. 8, a non-patterned doped amorphous silicon carbide layer 132' is formed. A phosphorus-containing amorphous silicon carbide layer as a doped amorphous silicon carbide layer 132' is formed on the surface of the ultra-thin oxide layer 131 by using the PECVD process with SiH₄, CO₂ and PH₃ ionization. Optionally, the thickness of the doped amorphous silicon carbide layer 132' ranges from 40 nm to 140 nm.

Step S143: as shown in FIG. 9, the mask layer 16 covering the doped amorphous silicon carbide layer 132' is formed. A layer of silicon oxide as the mask layer 16 is formed on the surface of the doped amorphous silicon carbide layer 132' by using the PECVD process with SiH₄ and N₂O ionization. Optionally, the thickness of the mask layer 16 is in a range of 10 nm to 30 nm.

As shown in FIG. 11, following the formation of the mask layer 16 but prior to patterning the mask layer 16, an annealing treatment is performed to crystallize the polycrystalline silicon layer 12 and the doped amorphous silicon carbide layer 132', and activate doping and ensure uniform distribution of the internal doped ions. Prior to patterning the mask layer 16, the annealing treatment is performed, based on the entire mask layer 16, to ensure uniform annealing temperatures for the doped amorphous silicon layer 12' and the doped amorphous silicon carbide layer 132', guarantee their crystallization effects,, and improve the distribution uniformity of the internal doped ions, so as to form high-quality doped polycrystalline silicon layer 12 and doped polycrystalline silicon carbide layer 132 after annealing.

In addition, compared with the method of etching the doped amorphous silicon carbide layer 132' to form a patterned doped amorphous silicon carbide layer 132' and then annealing to form the doped polycrystalline silicon carbide layer 132, the embodiment of the present application performs annealing first and then forms the patterned doped polycrystalline silicon carbide layer 132, which can make the doping ion distribution in the doped polycrystalline silicon carbide layer 132 more uniform. This is because the lateral size of the patterned doped amorphous silicon carbide layer 132'is small, in a case that annealing is performed after patterning, the edge effect would cause significant differences in doped ions distribution between the peripheral edge region and the central region of the formed doped polycrystalline silicon carbide layer 132. However, in the present application, the patterned doped polycrystalline silicon carbide layer 132 is formed after annealing, even if there is significant differences in doped ions distribution between the peripheral edge region and the central region of the doped polycrystalline silicon carbide layer 132 after annealing, the peripheral edge region can be removed after etching the doped polycrystalline silicon carbide layer 132, thus ensuring good uniformity of doped ion distribution in the doped polycrystalline silicon carbide layer 132..

Step S144: as shown in FIG. 11, the mask layer 16 is etched to form the required pattern structure, so as to facilitate the subsequent etching of the doped polycrystalline silicon carbide layer 132. In this step, the laser etching can be used to remove the mask layer 16 in the non-metallic grid line region and expose the doped polycrystalline silicon carbide layer 132 in the non-metallic grid line region, and the mask layer 16 in the metallic grid line region is retained to protect the doped polycrystalline silicon carbide layer 132 in the metallic grid line region.

Step S145: as shown in FIG. 12, based on the etched mask layer 16, the doped polycrystalline silicon carbide layer 132 is etched to form the patterned doped polycrystalline silicon carbide layer 132. Wet etching may be used to remove the doped polycrystalline silicon carbide layer 132 not covered by the mask layer 16, and retain the doped polycrystalline silicon carbide layer 132 covered by the mask layer 16, thereby forming a patterned doped polycrystalline silicon carbide layer 132.

Step S146: as shown in FIG. 13, the mask layer 16 on the surface of the ultra-thin oxide layer 131 and the doped polycrystalline silicon carbide layer 132 in the non-metallic grid line region is etched and removed simultaneously. This step can not only etch the ultra-thin oxide layer 131 to form a patterned ultra-thin oxide layer 131, but also simultaneously remove the mask layer 16 on the surface of the doped polycrystalline silicon carbide layer 132.

The mask layer 16 and the ultra-thin oxide layer 131 are made of the same material so that the two can be etched and removed simultaneously, for example, both can be silicon oxide layers.

In one embodiment of the present application, the thickness of the mask layer 16 is greater than the thickness of the ultra-thin oxide layer 131, such that when the doped polycrystalline silicon carbide layer 132 is etched based on the mask layer 16, a portion of the thickness of the mask layer 16 is consumed, and at this time the mask layer 16 and the ultra-thin oxide layer 131 have the same or similar thickness, so that he mask layer 16 and the ultra-thin oxide layer 131 can be better etched and removed simultaneously.

The same PECVD equipment may be used to sequentially form the ultra-thin tunnel oxide layer 11, the doped amorphous silicon layer 12', the non-patterned bottom electrode contact layer 13 and the non-patterned mask layer 16 on the rear surface of the semiconductor substrate 10. As described above, after patterning the bottom electrode contact layer 13 based on the mask layer 16, the mask layer 16 is removed.

In one embodiment of the present application, there is no need to replace other process machines, and the ultra-thin tunnel oxide layer 11, the doped amorphous silicon layer 12', the non-patterned bottom electrode contact layer 13 and the non-patterned mask layer 16 can be sequentially formed in the same PECVD equipment, resulting in a simple manufacturing process and reduced production cost.

As mentioned above, the thickness of the doped polycrystalline silicon layer 12 ranges from 10 nm to 40 nm. The thickness of the doped polycrystalline silicon carbide layer 132 ranges from 40 nm to 140 nm, and/or, the spacing between two adjacent bottom electrodes 14 ranges from 0.85 mm to 0.95 mm. This can not only significantly reduce the thickness of the doped polycrystalline silicon layer 12, but also effectively solve the problem of metal material burning through the ultra-thin tunnel oxide layer 11 caused by the reduced thickness of the doped polycrystalline silicon layer 12, and overcome the problem of the weakened lateral carrier transport performance in the doped polycrystalline silicon layer 12 due to the reduced thickness of the doped polycrystalline silicon layer 12.

In one embodiment of the present application, the thickness of the doped polycrystalline silicon layer 12 is uniform, and there is no need for a differentiated thickness design of the doped polycrystalline silicon layer 12 in the metallic grid line region and the non-metallic grid line region. The doped polycrystalline silicon carbide layer 132 can prevent the metal material in the bottom electrode 14 from burning through the doped polycrystalline silicon layer 12.

Reference is made to FIG. 14, which is a schematic structural diagram of a TopCon solar cell provided in an embodiment of the present application. The structure may comprise: a substrate 1; where a surface of the substrate 1 has a metallic contact region and a non-metallic contact region;
a first tunnel layer 2, a doped polycrystalline silicon layer 3 and an electrode 7, where the first tunnel layer 2, the doped polycrystalline silicon layer 3 and the electrode 7 are located in sequence in the metallic contact region along a direction away from the substrate 1, and the electrode 7 is in ohmic contact with the doped polycrystalline silicon layer 3;
a second tunnel layer 4 and a doped polycrystalline silicon carbide layer 5, where the second tunnel layer 4 and the doped polycrystalline silicon carbide layer 5 are located in sequence in the non-metallic contact region along a direction away from the substrate 1; and a light absorption coefficient of the doped polycrystalline silicon carbide layer 5 is less than a light absorption coefficient of the doped polycrystalline silicon layer 3.

In the embodiment, the specific type of the substrate 1 is not limited, for example, the substrate 1 may be doped single crystal silicon, including but not limited to phosphorus-doped N-type single crystal silicon, boron-doped or gallium-doped P-type single crystal silicon.

This embodiment does not limit the specific location of the passivation structure formed by the first tunnel layer 2, the doped polycrystalline silicon layer 3, the second tunnel layer 4 and the doped polycrystalline silicon carbide layer 5, for example, the passivation structure may be located on the front surface of the substrate 1, may also be located on the rear surface of the substrate 1; and may also be located on both the front surface and the rear surface of the substrate 1.

This embodiment does not limit the specific type of the first tunnel layer 2, for example, the first tunnel layer 2 may be a tunnel oxide layer, including but not limited to a silicon oxide layer containing phosphorus or boron, a silicon oxynitride layer, an aluminum oxide layer, and an aluminum oxynitride layer. This embodiment does not limit the specific thickness of the first tunnel layer 2, for example, the thickness of the first tunnel layer 2 may be 0.5 nm to 2 nm, inclusive of both endpoints.

This embodiment does not limit the specific type of the second tunnel layer 4, for example, the second tunnel layer 4 may be a tunnel oxide layer, including but not limited to a silicon oxide layer containing phosphorus or boron, a silicon oxynitride layer, an aluminum oxide layer, and an aluminum oxynitride layer. This embodiment does not limit the specific thickness of the second tunnel layer 4, for example, the thickness of the second tunnel layer 4 may be 0.5 nm to 2 nm, inclusive of both endpoints.

The present embodiment does not limit the specific type of the doped polycrystalline silicon layer 3, for example, the doped polycrystalline silicon layer 3 may be a polycrystalline silicon layer doped with phosphorus or boron. The present embodiment does not limit the specific activated impurity concentration of the doped polycrystalline silicon layer 3, for example, the activated impurity concentration of the doped polycrystalline silicon layer 3 may be 1×10 ²⁰ cm⁻³ to 1×10 ²¹ cm⁻³, inclusive of both endpoints. The present embodiment does not limit the specific thickness of the doped polycrystalline silicon layer 3, for example, the thickness of the doped polycrystalline silicon layer 3 may be 20 nm to 100 nm, inclusive of both endpoints.

The present embodiment does not limit the specific type of doped polycrystalline silicon carbide layer 5, for example, the doped polycrystalline silicon carbide layer 5 may be a polycrystalline silicon carbide layer doped with phosphorus or boron. The present embodiment does not limit the specific activated impurity concentration of the doped polycrystalline silicon carbide layer 5, for example, the activated impurity concentration of the doped polycrystalline silicon carbide layer 5 may be 1×10 ²⁰ cm⁻³ to 1×10 ²¹ cm⁻³, inclusive of both endpoints. This embodiment does not limit the specific thickness of the doped polycrystalline silicon carbide layer 5. For example, the thickness of the doped polycrystalline silicon carbide layer 5 may be 20 nm to 50 nm, inclusive of both endpoints. It should be noted that when the doped polycrystalline silicon carbide layer 5 covers both the non-metallic contact region and the metallic contact region, the thinner the thickness of the doped polycrystalline silicon carbide layer 5, the more conducive it is for the slurry of the electrode 7 to burn through the second tunnel layer 4 and contact the doped polycrystalline silicon layer 3.

When the doped polycrystalline silicon carbide layer 5 covers the metallic contact region, the doped polycrystalline silicon carbide layer 5 located in the metallic contact region may also be configured to control a metallization depth of the electrode 7 during the sintering process of the electrode 7, so that the electrode 7 is in an ohmic contact with the doped polycrystalline silicon layer 3 located in the metallic contact region, and the metallization range does not exceed the metallic contact region. Herein, the structure can prevent the metal material of the electrode 7 after sintering from burning through the first tunnel layer 2, avoid the problem of poor passivation contact effect of the first tunnel layer 2 caused thereby, improve the passivation contact effect of the first tunnel layer 2, avoid the metal material of the electrode 7 from directly contacting the substrate 1, and reduce metal contact recombination, thereby reducing parasitic absorption and improving photoelectric conversion efficiency.

Specifically, in one embodiment, the spacing between two adjacent electrodes 7 ranges from 0.85 mm to 0.95 mm.

This embodiment does not limit the specific widths of the metallic contact region and the non-metallic contact region. For example, the width of the metallic contact region may be 80 µm to 200 µm, inclusive of both endpoints. The width of the non-metallic contact region may be 1000 µm to 2000 µm, inclusive of both endpoints. It should be noted that in this embodiment, the pattern of the metallic contact region corresponds to the pattern of the metal electrode 7 and is distributed in a grid line shape.

This embodiment does not limit the specific type of material of the electrode 7. For example, the material of the electrode 7 may include but is not limited to silver, aluminum, copper and their alloys.

Furthermore, in the embodiment, the second tunnel layer 4 may cover the doped polycrystalline silicon layer 3 and the non-metallic contact region, the doped polycrystalline silicon carbide layer 5 may cover the second tunnel layer 4; and the electrode 7 penetrates the doped polycrystalline silicon carbide layer 5 and the second tunnel layer 4, and is in ohmic contact with the doped polycrystalline silicon layer 3. It should be noted that different materials are spatially distributed according to the metallic contact region and the non-metallic contact region. In one embodiment, the metallic contact region is a stack of the first tunnel layer 2, the doped polycrystalline silicon layer 3, the second tunnel layer 4 and the doped polycrystalline silicon carbide layer 5, and the non-metallic contact region is composed of the second tunnel layer 4 and the doped polycrystalline silicon carbide layer 5. In one embodiment, the step of patterning the second tunnel layer 4 and the doped polycrystalline silicon carbide layer 5 may be omitted in preparing this structure, thus making the preparation process simple.

Furthermore, in order to achieve anti-reflection and passivation functions, this embodiment can also comprise a passivating antireflection layer 6. The passivating antireflection layer 6 covers the surface of the doped polycrystalline silicon carbide layer 5 away from the substrate 1. The electrode 7 penetrates the passivating antireflection layer 6, the doped polycrystalline silicon carbide layer 5 and the second tunnel layer 4, and is in ohmic contact with the doped polycrystalline silicon layer 3.

The embodiment does not limit the specific type of the passivating antireflection layer 6. For example, the passivating antireflection layer 6 may comprise any one or more of a silicon nitride layer, a silicon oxynitride layer, a silicon oxide layer, an aluminum oxide layer, an aluminum nitride layer, an aluminum oxynitride layer, and a magnesium fluoride layer. The embodiment does not limit the specific thickness of the passivating antireflection layer 6. For example, the thickness of the passivating antireflection layer 6 may be 70 nm to 150 nm, inclusive of both endpoints.

Based on the above embodiments, the present application optimizes the passivation layer structure. In the metallic contact region, the doped polycrystalline silicon layer is retained, and forms a high-low junction with the substrate to provide field passivation, and forms the ohmic contact with the electrode. In the non-metallic contact region, the doped polycrystalline silicon carbide layer is provided to form a heterojunction with the substrate to provide field passivation and serve as a lateral carrier transport layer. On the one hand, the parasitic absorption of the passivation layer is reduced by removing the doped polycrystalline silicon layer in the non-metallic contact region. Moreover, due to the low light absorption coefficient and small thickness of the doped polycrystalline silicon carbide layer, the parasitic absorption can also be reduced. On the other hand, retaining the doped polycrystalline silicon layer in the metallic contact region to form the ohmic contact with the electrode can ensure low recombination loss when the doped polycrystalline silicon layer contacts the metal grid line. In addition, the field passivation is formed in both the metallic contact region and the non-metallic region, which ensures the passivation effect of the entire surface of the substrate.

Reference is made to FIG. 15, which is a flow chart of a method for manufacturing the TopCon solar cell provided by an embodiment of the present application. The method may comprise as follows.

S101: the first tunnel layer and the doped polycrystalline silicon layer are prepared in sequence in the metallic contact region on a surface of a substrate along a direction away from the substrate.

Furthermore, in order to remove contaminants and mechanical damage from the surface of the substrate 1 and form a polished or pyramid-textured morphology, the substrate 1 may be cleaned and dried before step S101. The embodiment does not limit the specific cleaning method, as long as it can ensure that the contaminants and mechanical damage on the surface of the substrate 1 can be removed and the polished or pyramid-textured morphology can be formed. For example, the substrate 1 may be cleaned and dried by wet chemical method.

This embodiment does not limit the specific method of preparing the first tunnel layer 2 and the doped polycrystalline silicon layer 3, as long as the first tunnel layer 2 and the doped polycrystalline silicon layer 3 may be formed in the metallic contact region. For example, the first tunnel layer 2 may be prepared on a surface of the substrate 1; after the first tunnel layer 2 is formed, the doped polycrystalline silicon layer 3 is prepared on a surface of the first tunnel layer 2 away from the substrate 1; after the doped polycrystalline silicon layer 3 is formed, a patterning process is performed to remove the doped polycrystalline silicon layer 3 and the first tunnel layer 2 in the non-metallic contact region.

This embodiment does not limit the specific method of preparing the first tunnel layer 2. The corresponding preparation method may be selected according to the specific type of the first tunnel layer 2. For example, when the first tunnel layer 2 is a tunnel oxide layer, high-temperature oxygen thermal oxidation or plasma-enhanced oxidation using nitrous oxide in a PECVD (Plasma Enhanced Chemical Vapor Deposition) device may be performed to oxidize the surface of the substrate 1, thereby forming the first tunnel layer 2 on the surface of the substrate 1.

This embodiment does not limit the specific method of preparing the doped polycrystalline silicon layer 3. For example, the PECVD device may be used to depositing a doped amorphous silicon layer on the surface of the first tunnel layer 2 away from the substrate 1, the reaction gas source may include but is not limited to silane, phosphine, diborane or hydrogen, after forming the doped amorphous silicon layer, the doped amorphous silicon layer is crystallized in an annealing device to form the doped polycrystalline silicon layer 3. This preparation method is an in-situ doping method. In addition, the doped amorphous silicon layer may be formed by impurity diffusion.

This embodiment does not limit the specific timing of crystallization. The doped amorphous silicon layer may be crystallized directly after the doped amorphous silicon layer is formed; or after preparing the doped amorphous silicon carbide layer, the doped amorphous silicon layer and the doped amorphous silicon carbide layer may be crystallized at the same time. This embodiment does not limit the specific value of the annealing temperature. For example, the annealing temperature may be 850°C to 1100°C, inclusive of both endpoints. This embodiment does not limit the specific type of annealing atmosphere, for example, the annealing atmosphere may be an inert gas such as nitrogen, argon, or a hydrogen-nitrogen mixture gas.

This embodiment does not limit the specific method of patterning process. For example, an oxidation mask may be prepared on the surface of the doped amorphous silicon layer away from the substrate 1; after forming the oxidation mask, the oxidation mask, the doped amorphous silicon layer and the first tunnel oxide layer located in the non-metallic contact region are removed; and after removing the first tunnel oxide layer, the oxidation mask located in the metallic contact region is removed.

This embodiment does not limit the specific type of the oxidation mask. For example, the oxidation mask may comprise a silicon oxide mask or a silicon oxynitride mask. This embodiment does not limit the specific method of preparing the oxidation mask, and the corresponding preparation method may be selected according to the specific type of the oxidation mask. For example, the oxidation mask may be deposited on the surface of the doped amorphous silicon layer away from the substrate 1 using the PECVD device. The reaction gas source includes but is not limited to silane, nitrous oxide or ammonia.

This embodiment does not limit the specific method of removing the oxidation mask located in the non-metallic contact region. For example, a laser may be used to open holes in the oxidation mask in the non-metallic contact region, or a barrier slurry may be printed on the surface of the oxidation mask in the metallic contact region, and after printing the barrier slurry, the oxidation mask in the non-metallic contact region may be removed by hydrofluoric acid etching. It should be noted that the oxidation mask in the metallic contact region may be directly removed by hydrofluoric acid etching.

This embodiment does not limit the specific method of removing the doped amorphous silicon layer in the non-metallic contact region. For example, the method may include, but is not limited to, removing the doped amorphous silicon layer in the non-metallic contact region by etching with an alkaline solution. It should be noted that in the process of removing the doped amorphous silicon layer, the first tunnel layer 2 may also be removed.

Furthermore, in one embodiment, after removing the oxidation mask in the metallic contact region, the surface of the substrate 1 may also be cleaned. The cleaning method includes but is not limited to water washing or RCA cleaning. Herein, the RCA cleaning is a wet chemical cleaning method.

S102: A second tunnel layer and a doped polycrystalline silicon carbide layer are prepared in sequence in a non-metallic contact region on the surface of the substrate along the direction away from the substrate, wherein the light absorption coefficient of the doped polycrystalline silicon carbide layer is less than the light absorption coefficient of the doped polycrystalline silicon layer.

Furthermore, in order to simplify the process flow, in one embodiment, after the doped polycrystalline silicon layer 3 is prepared, the second tunnel layer 4 and the doped polycrystalline silicon carbide layer 5 are sequentially prepared on the doped polycrystalline silicon layer 3 and in the non-metallic contact region in the direction away from the substrate 1. Accordingly, the electrode 7 is prepared so that the electrode 7 penetrates the doped polycrystalline silicon carbide layer 5 and the second tunnel layer 4 and is in ohmic contact with the doped polycrystalline silicon layer 3.

This embodiment does not limit the specific method of preparing the second tunnel layer 4. The corresponding preparation method may be selected according to the specific type of the second tunnel layer 4. For example, when the second tunnel layer 4 is the tunnel oxide layer, high-temperature oxygen thermal oxidation or plasma-enhanced oxidation using nitrous oxide in a PECVD device may be performed to oxidize the surface of the doped polycrystalline silicon layer 3 away from the substrate 1 and the non-metallic contact region, to form the second tunnel layer 4 on the surface of the doped polycrystalline silicon layer 3 away from the substrate 1 and in the non-metallic contact region.

This embodiment does not limit the specific method of preparing the doped polycrystalline silicon carbide layer 5. For example, the doped amorphous silicon carbide layer may be deposited on the surface of the second tunnel layer 4 away from the substrate 1 by using a PECVD device. The reaction gas source may include but is not limited to silane, phosphine, diborane or hydrogen. After the doped amorphous silicon carbide layer is formed, the doped amorphous silicon carbide layer is crystallized in an annealing device to form the doped polycrystalline silicon carbide layer 5. The preparation method is an in-situ doping method. In addition, the doped amorphous silicon carbide layer may be formed by impurity diffusion.

Furthermore, in order to achieve anti-reflection and passivation functions, in the embodiment, after step S102, the passivating antireflection layer 6 may further prepared on the surface of the doped polycrystalline silicon carbide layer 5 away from the substrate 1. Accordingly, the electrode 7 is prepared so that the electrode 7 penetrates the passivating antireflection layer 6, the doped polycrystalline silicon carbide layer 5 and the second tunnel layer 4, and is in ohmic contact with the doped polycrystalline silicon layer 3.

The present embodiment does not limit the specific type of the passivating antireflection layer 6. For example, the passivating antireflection layer 6 may comprise any one or more of a silicon nitride layer, a silicon oxynitride layer, a silicon oxide layer, an aluminum oxide layer, an aluminum nitride layer, an aluminum oxynitride layer, and a magnesium fluoride layer. This embodiment does not limit the specific method of preparing the passivating antireflection layer 6. The corresponding preparation method may be selected according to the specific type of the passivating antireflection layer 6. For example, the passivating antireflection layer 6 may be deposited on the surface of the doped polycrystalline silicon carbide layer 5 away from the substrate 1 by using a PECVD device or an ALD (Atomic Layer Deposition) device. The reaction gas source includes but is not limited to silane, ammonia, trimethylaluminum or nitrous oxide.

S103: After the doped polycrystalline silicon layer and the doped polycrystalline silicon carbide layer are prepared, an electrode is prepared in the metallic contact region such that the electrode is in ohmic contact with the doped polycrystalline silicon layer.

This embodiment does not limit the specific method of preparing the electrode 7. For example, the electrode 7 may be prepared in the metallic contact region by screen printing or electroplating. The screen printing method requires high-temperature sintering and annealing to volatilize the organic solvent in the metal slurry and allow glass powder particles to burn through the surface passivating antireflection layer 6, such that the metal particles form a metal-semiconductor contact with the doped polycrystalline silicon layer 3. The electroplating method requires laser pretreatment to remove the surface passivating antireflection layer 6 and doped polycrystalline silicon carbide layer 5 in the electroplated region, such that the electroplated metal forms a metal-semiconductor contact with the doped polycrystalline silicon layer 3.

Based on the above embodiments, the TopCon cell prepared optimizes the passivation layer structure. In the metallic contact region, the doped polycrystalline silicon layer is retained, and forms a high-low junction with the substrate to provide field passivation, and forms the ohmic contact with the electrode. In the non-metallic contact region, the doped polycrystalline silicon carbide layer is provided to form a heterojunction with the substrate to provide field passivation and serve as a lateral carrier transport layer. On the one hand, the parasitic absorption of the passivation layer is reduced by removing the doped polycrystalline silicon layer in the non-metallic contact region. Moreover, due to the low light absorption coefficient and small thickness of the doped polycrystalline silicon carbide layer, the parasitic absorption can also be reduced. On the other hand, retaining the doped polycrystalline silicon layer in the metallic contact region to form the ohmic contact with the electrode can ensure low recombination loss when the doped polycrystalline silicon layer contacts the metal grid line. In addition, the field passivation is formed in both the metallic contact region and the non-metallic region, which ensures the passivation effect of the entire surface of the substrate.

The following is a specific example to illustrate the process for manufacturing the TopCon solar cell. The process is as follows:
Step 1, cleaning: The silicon wafer is cleaned by wet chemical cleaning and dried to remove contaminants and mechanical damage on the surface of the silicon wafer, and form a polished or pyramid-textured morphology. The cleaning process is not restricted here.
Step 2, primary oxidation: The cleaned silicon wafer is subjected to a surface oxidation treatment by high-temperature oxygen thermal oxidation or plasma-enhanced oxidation by introducing nitrous oxide in a PECVD device to form a tunnel oxide layer on the surface of the silicon wafer.
Step 3, doped amorphous silicon deposition: The PECVD device is used to deposit on the coated surface of the silicon wafer to form the doped amorphous silicon film, where the reaction gas source is silane, phosphine, diborane or hydrogen.
Step 4, oxidation mask deposition: The PECVD device is used to deposit silicon oxide or silicon oxynitride mask on the surface of the doped amorphous silicon film, where the reaction gas source is silane, nitrous oxide or ammonia.
Step 5, patterning: Patterning and etching are performed on the oxidation mask and the doped amorphous silicon film, where the specific process comprises: preparing patterned oxidation mask, preparing patterned doped amorphous silicon film, hydrofluoric acid etching and post-cleaning.

Herein, the preparation of the patterned oxidation mask may include methods such as laser film opening, or barrier slurry printing and hydrofluoric acid etching, or the like, so as to remove the oxidation mask in the non-metallic contact region and retain the oxidation mask in metallic contact region.

The patterned doped amorphous silicon film can be obtained by removing the doped amorphous silicon film in the non-metallic contact region by alkaline solution etching. In the process of removing the doped amorphous silicon film, the tunnel oxide layer formed in step 2 may also be removed.

The residual oxidation mask in the metallic contact region is removed by hydrofluoric acid etching, and the silicon wafer surface is cleaned by water washing or RCA cleaning.

Step 6, secondary oxidation: The cleaned silicon wafer is subjected to surface oxidation treatment, by using high-temperature oxygen thermal oxidation or plasma-enhanced oxidation by introducing nitrous oxide in the PECVD device, and forming a tunnel oxide layer on the surface of the silicon wafer and the surface of the patterned doped amorphous silicon film.

Step 7, doped amorphous silicon carbide deposition: A PECVD equipment is used to deposit on the coated surface of the silicon wafer to form a doped amorphous silicon carbide film, where the reaction gas source is silane, methane, phosphine, diborane or hydrogen.

Step 8, high-temperature annealing crystallization: The silicon wafer is placed in a high-temperature annealing device at 850 °C to 1100 °C, where the doped amorphous silicon film prepared in step 3 and the doped amorphous silicon carbide film prepared in step 7 are crystallized to form a doped polycrystalline silicon film and a doped polycrystalline silicon carbide film. The annealing atmosphere is an inert gas such as nitrogen, argon, or a hydrogen-nitrogen mixture.

Step 9, surface passivation anti-reflection film deposition: Equipment such as PECVD and ALD are used to deposit on the coated surface of the silicon wafer, to form a surface passivating antireflection film on the doped polycrystalline silicon film. The reaction gas source is silane, ammonia, trimethylaluminum or nitrous oxide.

Step 10, metallization: A metal electrode with the same pattern as the metallic contact region is prepared by using screen printing or electroplating. The screen printing method requires high-temperature sintering and annealing to volatilize the organic solvent in the metal slurry and allow glass powder particles to burn through the surface passivating antireflection film, and enable the metal particles to form a metal-semiconductor contact with the doped polycrystalline silicon film. The electroplating method requires laser pretreatment to remove the surface passivating antireflection film and doped polycrystalline silicon carbide film in the electroplated region, such that the electroplated metal forms a metal-semiconductor contact with the doped polycrystalline silicon film.

In this specification, each embodiment is described in a progressive, parallel, or progressive and parallel manner. Each embodiment focuses on the differences from other embodiments, and the same and similar parts between the embodiments may be referred to each other.

It should be noted that in the description of the present application, it should be understood that the description of drawings and embodiments is illustrative rather than restrictive. The same figure marks throughout the embodiments of the specification identify the same structure. In addition, for the sake of understanding and ease of description, the drawings may exaggerate the thickness of some layers, films, panels, regions, or the like. Moreover, it can be understood that when an element such as a layer, film, region or substrate is referred to as "on" another element, the element may be directly on the other element or there can be an intermediate element. In addition, "on..." means positioning an element on or below another element, but does not essentially mean positioning on the upper side of another element according to the direction of gravity.

The orientation or position relationship indicated by the terms "upper", "lower", "top", "bottom", "inside", "outside", or the like is based on the orientation or position relationship shown in the drawings, and is only for the convenience of describing the present application and simplifying the description, rather than indicating or implying that the device or element referred to must have a specific orientation, be constructed and operated in a specific orientation, and therefore cannot be understood as a limitation on the present application. When a component is considered to be "connected" to another component, it may be directly connected to another component or there may be a centrally arranged component at the same time.

It should be noted that in the present application, relational terms such as first and second are only used to distinguish one entity or operation from another entity or operation, and do not necessarily require or imply any such actual relationship or order between these entities or operations. Moreover, the terms "include", "comprise" or any other variant thereof are intended to cover non-exclusive inclusion, so that an article or device including a series of elements includes not only those elements, but also other elements not explicitly listed, or further includes elements inherent to such article or device. In the absence of further restrictions, the elements defined by the sentence "including one..." do not exclude the existence of other identical elements in the article or device including the above elements.

The above description of the disclosed embodiments enables those skilled in the art to implement or use the present application. Various modifications to these embodiments will be apparent to those skilled in the art, and general principles defined herein may be implemented in other embodiments without departing from the spirit or scope of the present application. Therefore, the present application will not be limited to the embodiments shown herein, but will conform to the widest scope consistent with the principles and novel features disclosed herein.

## Claims

1. An ultra-thin tunnel oxide passivated contact solar cell, wherein the ultra-thin tunnel oxide passivated contact solar cell comprises:
a semiconductor substrate, wherein the semiconductor substrate has a front surface and a rear surface opposite to each other, and the rear surface has a metallic grid line region and a non-metallic grid line region located on both sides of the metallic grid line region;
an ultra-thin tunnel oxide layer covering the rear surface;
a doped polycrystalline silicon layer covering the ultra-thin tunnel oxide layer;
a patterned bottom electrode contact layer, located on a surface of the doped polycrystalline silicon layer away from the ultra-thin tunnel oxide layer and located in the metallic grid line region; and
a bottom electrode, located on a surface of the bottom electrode contact layer away from the doped polycrystalline silicon layer;
wherein the bottom electrode contact layer comprises: an ultra-thin oxide layer located on the surface of the doped polycrystalline silicon layer and a doped polycrystalline silicon carbide layer located on a surface of the ultra-thin oxide layer, and the doped polycrystalline silicon carbide layer is configured to control a metallization depth of the bottom electrode during a sintering process of the bottom electrode, such that the bottom electrode is in an ohmic contact with the doped polycrystalline silicon layer and a metallization range does not exceed the doped polycrystalline silicon layer.

2. The ultra-thin tunnel oxide passivated contact solar cell according to claim 1, wherein a thickness of the doped polycrystalline silicon layer ranges from 10 nm to 40 nm.

3. The ultra-thin tunnel oxide passivated contact solar cell according to claim 2, wherein a thickness of the doped polycrystalline silicon carbide layer ranges from 40 nm to 140 nm.

4. The ultra-thin tunnel oxide passivated contact solar cell according to claim 2, wherein a spacing between two adjacent bottom electrodes ranges from 0.85 mm to 0.95 mm.

5. The ultra-thin tunnel oxide passivated contact solar cell according to any one of claims 1 to 4, further comprising:
a silicon nitride passivation layer, wherein the silicon nitride passivation layer is located on the surface of the doped polycrystalline silicon layer away from the ultra-thin tunnel oxide layer and located in the non-metallic grid line region while exposing the bottom electrode contact layer.

6. The ultra-thin tunnel oxide passivated contact solar cell according to claim 5, wherein a thickness of the silicon nitride passivation layer is 70 nm to 150 nm, inclusive of both endpoints.

7. The ultra-thin tunnel oxide passivated contact solar cell according to claim 1, wherein a light absorption coefficient of the doped polycrystalline silicon carbide layer is less than a light absorption coefficient of the doped polycrystalline silicon layer.

8. The ultra-thin tunnel oxide passivated contact solar cell according to claim 1, wherein an activated impurity concentration of the doped polycrystalline silicon layer is 1×10 ²⁰ cm⁻³ to 1×10 ²¹ cm⁻³, inclusive of both endpoints.

9. The ultra-thin tunnel oxide passivated contact solar cell according to claim 1, wherein an activated impurity concentration of the doped polycrystalline silicon carbide layer is 1×10 ²⁰ cm⁻³ to 1×10 ²¹ cm⁻³, inclusive of both endpoints.

10. The ultra-thin tunnel oxide passivated contact solar cell according to claim 1, wherein a width of the metallic grid line region is 80 µm to 200 µm, inclusive of both endpoints, and a width of the non-metallic grid line region is 1000 µm to 2000 µm, inclusive of both endpoints.

11. A method for manufacturing the ultra-thin tunnel oxide passivated contact solar cell according to any one of claims 1 to 5, wherein the method comprises:
providing the semiconductor substrate, wherein the semiconductor substrate has a front surface and a rear surface opposite to each other, and the rear surface has a metallic grid line region and a non-metallic grid line region located on both sides of the metallic grid line region;
forming the ultra-thin tunnel oxide layer covering the rear surface;
forming the doped polycrystalline silicon layer and the bottom electrode contact layer, wherein the doped polycrystalline silicon layer covers the ultra-thin tunnel oxide layer, the patterned bottom electrode contact layer is formed on the surface of the doped polycrystalline silicon layer away from the ultra-thin tunnel oxide layer and located in the metallic grid line region; and
forming the bottom electrode on the surface of the bottom electrode contact layer away from the doped polycrystalline silicon layer;
wherein the bottom electrode contact layer comprises: the ultra-thin oxide layer located on the surface of the doped polycrystalline silicon layer and the doped polycrystalline silicon carbide layer located on the surface of the ultra-thin oxide layer, and the doped polycrystalline silicon carbide layer is configured to control the metallization depth of the bottom electrode during the sintering process of the bottom electrode, such that the bottom electrode is in an ohmic contact with the doped polycrystalline silicon layer and the metallization range does not exceed the doped polycrystalline silicon layer.

12. The method according to claim 11, wherein the ultra-thin tunnel oxide layer, a doped amorphous silicon layer, a non-patterned bottom electrode contact layer and a non-patterned mask layer are sequentially formed on the rear surface by using the same PECVD device;
wherein the doped amorphous silicon layer is for forming the doped polycrystalline silicon layer based on an annealing process; the bottom electrode contact layer is patterned based on the mask layer, and then the mask layer is removed.

13. The method according to claim 11, wherein a thickness of the doped polycrystalline silicon layer ranges from 10 nm to 40 nm.

14. The method according to claim 13, wherein a thickness of the doped polycrystalline silicon carbide layer ranges from 40 nm to 140 nm;
and/or, a spacing between two adjacent bottom electrodes ranges from 0.85 mm to 0.95 mm.

15. The method according to claim 11, wherein a method for forming the doped polycrystalline silicon layer and the bottom electrode contact layer comprises:
forming the doped amorphous silicon layer on a surface of the ultra-thin tunnel oxide layer;
forming a non-patterned ultra-thin oxide layer and a non-patterned doped amorphous silicon carbide layer in sequence on a surface of the doped polycrystalline silicon layer;
forming a mask layer on a surface of the doped amorphous silicon carbide layer away from the ultra-thin oxide layer, and then annealing to convert the doped amorphous silicon layer into the doped polycrystalline silicon layer and convert the doped amorphous silicon carbide layer into the doped polycrystalline silicon carbide layer;
patterning the mask layer, wherein the patterned mask layer covers the doped polycrystalline silicon carbide layer located in the metallic grid line region and exposes the doped polycrystalline silicon carbide layer located in the non-metallic grid line region;
etching and removing the doped polycrystalline silicon carbide layer located in the non-metallic grid line region based on the patterned mask layer;
simultaneously removing the ultra-thin oxide layer and the mask layer located in the non-metallic grid line region; wherein the ultra-thin oxide layer and the mask layer are made of the same material.

16. A TopCon cell, wherein the TopCon cell comprises:
a substrate, wherein a surface of the substrate has a metallic contact region and a non-metallic contact region;
a first tunnel layer, a doped polycrystalline silicon layer and an electrode, wherein the first tunnel layer, the doped polycrystalline silicon layer and the electrode are located in sequence in the metallic contact region along a direction away from the substrate, and the electrode is in ohmic contact with the doped polycrystalline silicon layer;
a second tunnel layer and a doped polycrystalline silicon carbide layer, wherein the second tunnel layer and the doped polycrystalline silicon carbide layer are located in sequence in the non-metallic contact region along a direction away from the substrate, and a light absorption coefficient of the doped polycrystalline silicon carbide layer is less than a light absorption coefficient of the doped polycrystalline silicon layer.

17. The TopCon cell according to claim 16, wherein the second tunnel layer covers the doped polycrystalline silicon layer and the non-metallic contact region;
the doped polycrystalline silicon carbide layer covers the second tunnel layer;
the electrode penetrates the doped polycrystalline silicon carbide layer and the second tunnel layer, and is in ohmic contact with the doped polycrystalline silicon layer.

18. The TopCon cell according to claim 17, further comprising a passivating antireflection layer, wherein the passivating antireflection layer covers a surface of the doped polycrystalline silicon carbide layer away from the substrate;
the electrode penetrates the passivating antireflection layer, the doped polycrystalline silicon carbide layer and the second tunnel layer, and is in ohmic contact with the doped polycrystalline silicon layer.

19. The TopCon cell according to claim 18, wherein the passivating antireflection layer comprises any one or more selected from the group consisting of a silicon nitride layer, a silicon oxynitride layer, a silicon oxide layer, an aluminum oxide layer, an aluminum nitride layer, an aluminum oxynitride layer and a magnesium fluoride layer.

20. The TopCon cell according to claim 18, wherein a thickness of the passivating antireflection layer is 70 nm to 150 nm, inclusive of both endpoints.

21. The TopCon cell according to claim 16, wherein an activated impurity concentration of the doped polycrystalline silicon layer is 1×10 ²⁰ cm⁻³ to 1×10 ²¹ cm⁻³, inclusive of both endpoints;
a thickness of the doped polycrystalline silicon layer is 20 nm to 100 nm, inclusive of both endpoints.

22. The TopCon cell according to claim 16, wherein an activated impurity concentration of the doped polycrystalline silicon carbide layer is 1×10 ²⁰ cm⁻³ to 1×10 ²¹ cm⁻³, inclusive of both endpoints;
a thickness of the doped polycrystalline silicon carbide layer is 20 nm to 50 nm, inclusive of both endpoints.

23. The TopCon cell according to claim 16, wherein a width of the metallic contact region is 80 µm to 200 µm, inclusive of both endpoints; a width of the non-metallic contact region is 1000 µm to 2000 µm, inclusive of both endpoints.

24. The TopCon cell according to claim 17, wherein the doped polycrystalline silicon carbide layer located in the metallic contact region is configured to control a metallization depth of the electrode during a sintering process of the electrode, such that the electrode is in an ohmic contact with the doped polycrystalline silicon layer located in the metallic contact region, and the metallization range does not exceed the metallic contact region.

25. The TopCon cell according to claim 16, wherein a spacing between two adjacent electrodes ranges from 0.85 mm to 0.95 mm.

26. A method for manufacturing a TopCon cell, wherein the method comprises:
preparing a first tunnel layer and a doped polycrystalline silicon layer in sequence in a metallic contact region on a surface of a substrate along a direction away from the substrate;
preparing a second tunnel layer and a doped polycrystalline silicon carbide layer in sequence in a non-metallic contact region on the surface of the substrate along the direction away from the substrate, wherein a light absorption coefficient of the doped polycrystalline silicon carbide layer is less than a light absorption coefficient of the doped polycrystalline silicon layer;
after preparing the doped polycrystalline silicon layer and the doped polycrystalline silicon carbide layer, preparing an electrode in the metallic contact region such that the electrode is in ohmic contact with the doped polycrystalline silicon layer.

27. The method for manufacturing the TopCon cell according to claim 26, wherein the preparing the second tunnel layer and the doped polycrystalline silicon carbide layer in sequence in the non-metallic contact region on the surface of the substrate along the direction away from the substrate comprises:
after preparing the doped polycrystalline silicon layer, preparing the second tunnel layer and the doped polycrystalline silicon carbide layer in sequence on the doped polycrystalline silicon layer and in the non-metallic contact region along the direction away from the substrate;
correspondingly, preparing the electrode in the metallic contact region such that the electrode is in ohmic contact with the doped polycrystalline silicon layer comprises:
preparing the electrode, such that the electrode penetrates the doped polycrystalline silicon carbide layer and the second tunnel layer, and is in ohmic contact with the doped polycrystalline silicon layer.
